(19) **Europäisches Patentamt**
**European Patent Office**
**Office européen des brevets**

(11) **EP 4 733 790 A1**

(12) **EUROPEAN PATENT APPLICATION**
published in accordance with Art. 153(4) EPC

(43) Date of publication:
**29.04.2026 Bulletin 2026/18**

(21) Application number: **24849405.6**

(22) Date of filing: **08.07.2024**

(51) International Patent Classification (IPC):
*G01R 31/396* (2019.01)  *G01R 31/382* (2019.01)
*G01R 31/392* (2019.01)  *G01R 31/36* (2020.01)
*H01M 10/48* (2006.01)  *H01M 10/0525* (2010.01)

(52) Cooperative Patent Classification (CPC):
**G01R 31/36; G01R 31/382; G01R 31/392;**
**G01R 31/396; H01M 10/0525; H01M 10/48;**
Y02E 60/10

(86) International application number:
**PCT/KR2024/009663**

(87) International publication number:
**WO 2025/028835 (06.02.2025 Gazette 2025/06)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **28.07.2023 KR 20230099066**

(71) Applicant: **LG Energy Solution, Ltd.**
**Seoul 07335 (KR)**

(72) Inventor: **CHOI, Yean Sik**
**Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT APPARATUS AND OPERATION METHOD THEREFOR**

(57) A battery pack according to an embodiment disclosed herein includes a plurality of battery modules and a battery management apparatus configured to obtain a state of charge (SOC) and/or a state of health (SOH) of each of the plurality of battery modules, determine at least one first battery modules based on the SOC of each of the plurality of battery modules, and determine an activation rate of each of the at least one first battery modules, based on SOHs of the first battery modules.

200

FIG.2

EP 4 733 790 A1

**Description**

**TECHNICAL FIELD**

CROSS-REFERENCE TO RELATED APPLICATION

This application claims priority to and the benefit of Korean Patent Application No. 10-2023-0099066 filed in the Korean Intellectual Property Office on July 28, 2023, the entire content of which is incorporated herein by reference.

TECHNICAL FIELD

Embodiments disclosed herein relate to a battery management apparatus and an operating method thereof.

**BACKGROUND ART**

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Recently, the lithium ion battery is attracting attention as a next-generation energy storage medium as a usage range thereof is expanded to a power source of electric vehicles.

An electric vehicle is supplied with electricity from outside to charge a battery cell/module, and then the battery cell/module is discharged to drive a motor and obtain power. The battery cell/module undergoes internal deformation and denaturation through various chares/discharges in production and use phases, such that physical and chemical characteristics thereof change. A technique for diagnosing and managing operations of the battery cell/module due to degradation and deterioration of a battery is required.

For various purposes such as performance diagnosis, state analysis, etc., of the battery, a charging/discharging test may be conducted on the battery. For example, a test voltage may be applied to the battery, and a test result voltage may be measured from the battery in response to the test voltage. A state of charge (SOC) and/or a state of health (SOH) of a battery module may be obtained based on the test result voltage. By analyzing such a test result, an operation may be managed for each battery module.

**DISCLOSURE**

**TECHNICAL PROBLEM**

Embodiments disclosed herein aim to provide a battery management apparatus and an operating method thereof in which heat generated in each of battery modules included in a battery pack may be managed.

Embodiments disclosed herein aim to provide a battery management apparatus and an operating method thereof in which an activation rate of each of battery modules included in a battery pack may be determined to control an operation of each of the battery modules.

Technical problems of the embodiments disclosed herein are not limited to the above-described technical problems, and other unmentioned technical problems would be clearly understood by one of ordinary skill in the art from the following description.

**TECHNICAL SOLUTION**

a battery pack according to an embodiment disclosed herein includes a plurality of battery modules; and a battery management apparatus configured to: obtain a state of charge (SOC) and/or a state of health (SOH) of each of the plurality of battery modules, determine one or more first battery modules based on the SOC of each of the plurality of battery modules, and determine an activation rate of each of the first battery modules based on the SOH of each of the first battery modules.

According to an embodiment, the battery management apparatus may be further configured to compare the SOC of each of the plurality of battery modules with a first reference SOC and determine, as the first battery modules, battery modules having SOCs greater than or equal to the first reference SOC.

According to an embodiment, the battery management apparatus may be further configured to determine the first reference SOC based on an average and a standard deviation of the SOCs of the plurality of battery modules.

According to an embodiment, the battery management apparatus may be further configured to compare the SOHs of the first battery modules with a first reference SOH and determine one or more second battery modules having SOHs less than the first reference SOH.

According to an embodiment, the battery management apparatus may be further configured to determine a sum of activation rates of the second battery modules, where a sum of the activation rates of the second battery modules is equal to an activation rate of one of the first battery modules having SOHs greater than the first reference SOH.

According to an embodiment, the battery management apparatus may be further configured to determine the first reference SOH to be a minimum SOH between an SOH corresponding to a use year of the battery pack and/or an SOH corresponding to a discharging cycle number of the battery pack.

According to an embodiment, the battery management apparatus may be further configured to determine an activation expectation of each of the second battery modules based on the SOH of each of the second battery modules, determine an activation rate of each of the second battery modules based on the activation expectation, and control an operation period of each of the second battery modules based on the activation rate of each of the second battery modules.

According to an embodiment, the battery management apparatus may be further configured to compare the SOC of each of the plurality of battery modules with a first reference SOC, determine a battery module having an SOC less than the first reference SOC as a third battery module, and control the third battery module to be in a deactivated state.

According to an embodiment, the battery management apparatus may be further configured to adjust an activation rate of each of the first battery modules, where a sum of the activation rate of each of the first battery modules is greater than or equal to a predetermined activation rate for the battery pack.

According to an embodiment, each of the plurality of battery modules may include a battery cell, a first switch disposed on a charging/discharging line of the battery cell, and a second switch disposed on a bypass line connected in parallel to the charging/discharging line, and the battery management apparatus may be further configured to control an operation period of each of the first battery modules by controlling the first switch and the second switch according to the activation rate.

A management method of a battery pack according to an embodiment disclosed herein includes obtaining a state of charge (SOC) and/or a state of health (SOH) of each of a plurality of battery modules, determining one or more first battery modules based on the SOC of each of the plurality of battery modules, and determining an activation rate of each of the first battery modules based on SOH of each of the first battery modules.

According to an embodiment, the determining of the first battery modules may include comparing the SOC of each of the plurality of battery modules with a first reference SOC and determining, as the first battery modules, battery modules having an SOC greater than or equal to the first reference SOC.

According to an embodiment, the determining of the first battery modules may include determining the first reference SOC based on an average and a standard deviation of SOCs of the plurality of battery modules.

According to an embodiment, the determining of the activation rate of each of the first battery modules may include comparing the SOHs of the first battery modules with a first reference SOH and determining one or more second battery modules having SOHs less than the first reference SOH.

According to an embodiment, the determining of the activation rate of each of the first battery modules may include determining a sum of activation rates of the second battery modules, where a sum of the activation rates of the second battery modules is equal to an activation rate of one of the first battery modules having SOHs greater than the first reference SOH.

According to an embodiment, the determining of the second battery modules may include determining the first reference SOH to be a minimum SOH between an SOH corresponding to a use year of the battery pack and/or an SOH corresponding to a discharging cycle number of the battery pack.

According to an embodiment, the management method may further include determining an activation expectation of each of the second battery modules based on the SOH of each of the second battery modules, determining an activation rate of each of the second battery modules based on the activation expectation, and controlling an operation period of each of the second battery modules based on the activation rate of each of the second battery modules.

According to an embodiment, the management method may further include comparing the SOC of each of the plurality of battery modules with a first reference SOC, determining a battery module having an SOC less than the first reference SOC as a third battery module, and controlling the third battery module to be in a deactivated state.

According to an embodiment, the management method may further include adjusting an activation rate of each of the first battery modules, where a sum of the activation rate of each of the first battery modules is greater than or equal to a predetermined activation rate for the battery pack.

According to an embodiment, the management method may further include controlling an operation period of each of the first battery modules by controlling, according to the activation rate, a first switch disposed on a charging/discharging line of the battery cell and a second switch disposed on a bypass line connected in parallel to the charging/discharging line.

## ADVANTAGEOUS EFFECTS

The battery management apparatus and the operating method thereof according to an embodiment disclosed herein may manage heat generated from each of battery modules included in a battery pack.

The battery management apparatus and the operating method thereof according to an embodiment disclosed herein may determine an activation rate of each of battery modules included in a battery pack to control an operation of each of the battery modules.

Moreover, various effects recognized directly or indirectly from the disclosure may be provided.

## DESCRIPTION OF DRAWINGS

FIG. 1 illustrates a battery pack according to an embodiment disclosed herein.
FIG. 2 is a block diagram of a battery management apparatus according to an embodiment disclosed herein.
FIG. 3 is a circuit diagram of a battery module according to an embodiment disclosed herein.
FIG. 4 is a graph showing an operation of a battery module according to an embodiment disclosed herein.
FIG. 5A is a graph showing a state of charge (SOC) of a battery module at first time of a charging operation, according to an embodiment disclosed herein.
FIG. 5B is a graph showing an SOC of a battery module at second time of a charging operation, according to an embodiment disclosed herein.
FIG. 5C is a graph showing an SOC of a battery module at third time of a charging operation, according to an embodiment disclosed herein.
FIG. 6 is a flowchart of a discharging operation of a battery management apparatus, according to an embodiment disclosed herein.
FIG. 7 is a chart showing an activation rate determining process of a battery management apparatus, according to an embodiment disclosed herein.
FIG. 8 is a flowchart of a discharging operation of a battery management apparatus, according to an embodiment disclosed herein.
FIG. 9A is a chart showing an activation rate determining process of a battery management apparatus, according to another embodiment disclosed herein.
FIG. 9B is a chart showing an activation rate determining process of a battery management apparatus, according to yet another embodiment disclosed herein.
FIG. 10 is a block diagram showing a hardware configuration of a computing system for performing an operating method of a battery management apparatus, according to an embodiment disclosed herein.

## MODE FOR INVENTION

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

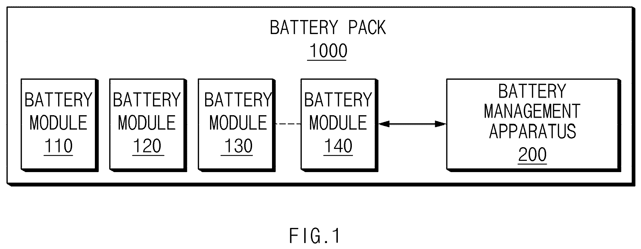

FIG. 1 illustrates a battery pack according to an embodiment disclosed herein.

Referring to FIG. 1, a battery pack 1000 may include a plurality of battery modules 110, 120, 130, ..., 140, and a battery management apparatus 200. Although the plurality of battery modules 110, 120, 130, ..., 140 are illustrated as four in FIG. 1, the present disclosure is not limited thereto, and the battery pack 1000 may include n battery modules (n is a natural number equal to or greater than 2). In addition, some components may be excluded from the battery pack 1000 or other general-purpose components may be further included in the battery pack 1000.

The plurality of battery modules 110, 120, 130, ..., 140 may supply power to a target device (not shown). To this end, the plurality of battery modules 110, 120, 130, ..., 140 may be electrically connected to the target device. Herein, the target device may include an electrical, electronic, or mechanical device that operates by receiving power from the battery pack 1000 including the plurality of battery modules 110, 120, 130, ..., 140. For example, the target device may be, but not limited to, an electric vehicle (EV) or an energy storage system (ESS).

Each of the plurality of battery modules 110, 120, 130, ..., 140 may include a plurality of battery cells (not shown). Each of the plurality of battery modules 110, 120, 130, ..., 140 may include n battery cells (n is a natural number greater than or equal to 2). The plurality of battery cells (not shown) may be a basic unit of a battery cell available through charging/discharging of electric energy. For example, the battery cell may be a lithium ion (Li-ion) battery, an Li-ion polymer battery, a nickel-cadmium (Ni-Cd) battery, a nickel hydrogen (Ni-MH) battery, etc., and is not limited thereto.

The battery management apparatus (a battery management system (BMS)) 200 may manage and/or control a state and/or an operation of each of the plurality of battery modules 110, 120, 130, ..., 140. For example, the battery management apparatus 200 may manage a charging and/or discharging operation of each of the plurality of battery modules 110, 120, 130, ..., 140.

The battery management apparatus 200 may also monitor a voltage, a current, a temperature, etc., of each of the plurality of battery modules 110, 120, 130, ..., 140 and/or each of the plurality of battery cells included in each of the plurality of battery modules 110, 120, 130, ..., 140. A sensor or various measurement modules for monitoring performed by the battery management apparatus 200, which are not shown, may be additionally installed in the plurality of battery modules 110, 120, 130, ..., 140, a charging/discharging path, any position of the plurality of battery cells (not shown) included in each of the plurality of battery modules 110, 120, 130, ..., 140. The battery management apparatus 200 may calculate a parameter indicating a state of each of the plurality of battery modules 110, 120, 130, ..., 140, e.g., a state of charge (SOC), a state of health (SOH) etc., based on a measurement value such as monitored voltage, current, temperature, etc.

For the plurality of battery modules 110, 120, 130, ..., 140, as a period of use or the number of times of use increases, a capacity may decrease, internal resistance may increase, and various factors of the battery may change differently. Thus, lifetime and performance of each of the plurality of battery modules 110, 120, 130, ..., 140 may change according to the use of the battery pack 1000. The battery management apparatus 200 may control a charging/discharging operation of each of the plurality of battery modules 110, 120, 130, ..., 140 based on a state of each of the plurality of battery modules 110, 120, 130, ..., 140, thereby managing heat generated from each of the plurality of battery modules 110, 120, 130, ..., 140. In this way, the battery management apparatus 200 may perform heat management of the battery pack 1000. In addition, the lifetime and performance of the plurality of battery modules 110, 120, 130, ..., 140 and/or the battery pack 1000 may be efficiently managed through heat management.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

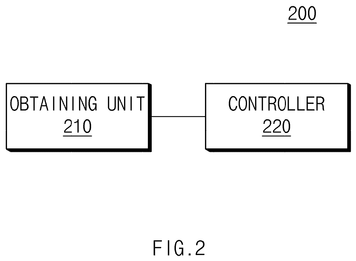

FIG. 2 is a block diagram of a battery management apparatus according to an embodiment disclosed herein.

Referring to FIG. 2, the battery management apparatus 200 may include a obtaining unit 210 and a controller 220. However, without being limited thereto, some components may be omitted from the battery management apparatus 200 or other general-purpose components may be further included in the battery management apparatus 200.

The obtaining unit 210 may obtain state information of each of the plurality of battery modules 110, 120, 130, ..., 140. The obtaining unit 210 may obtain an SOC and/or an SOH of each of the plurality of battery modules 110, 120, 130, ..., 140. The SOC and/or the SOH obtained by the obtaining unit 210 may be calculated by the controller 220 of the battery pack 1000 or may be calculated by a battery management apparatus (not shown) included in each of the plurality of battery modules 110, 120, 130, ..., 140.

The controller 220 may control an operation of the battery management apparatus 200. The controller 220 may control the operation of each of the plurality of battery modules 110, 120, 130, ..., 140, based on the SOC and the SOH obtained by the obtaining unit 210.

The controller 220 may control a charging and/or discharging operation of each of the plurality of battery modules 110, 120, 130, ..., 140. The controller 220 may control a charging state or a discharging state, i.e., an activation state, of each of the plurality of battery modules 110, 120, 130, ..., 140. The controller 220 may determine an activation rate which is a rate in which each of the plurality of battery modules 110, 120, 130, ..., 140 is activated. For example, each of the plurality of battery modules 110, 120, 130, ..., 140 may operate according to an activation rate in a charging and/or discharging state. According to an embodiment, an operation period of each of the plurality of battery modules 110, 120, 130, ..., 140 may be determined according to the activation rate.

The controller 220 may have a structure for executing instructions that implement the operations of the battery management apparatus 200. The controller 220 may be implemented with an array of multiple logic gates or a general-purpose microprocessor for processing various operations, and may include a single processor or a plurality of processors. For example, the controller 220 may be implemented in the form of at least one of a microprocessor, a CPU, a GPU, and an AP.

The controller 220 may be configured separately from or integrally with a memory and/or a storage configured to store instructions, and may process various operations by executing the instructions stored in the memory and/or the storage. The memory and/or the storage may store various data, instructions, mobile applications, computer programs, etc. For example, the memory and/or the storage may be implemented in the form of a non-volatile memory device such as ROM, PROM, EPROM, EEPROM, flash memory, PRAM, MRAM, RRAM, FRAM, etc., a volatile memory device such as DRAM, SRAM, SDRAM, PRAM, RRAM, FeRAM, etc., or a form such as HDD, SSD, SD, Micro-SD, etc., or may be implemented in the form of a combination thereof.

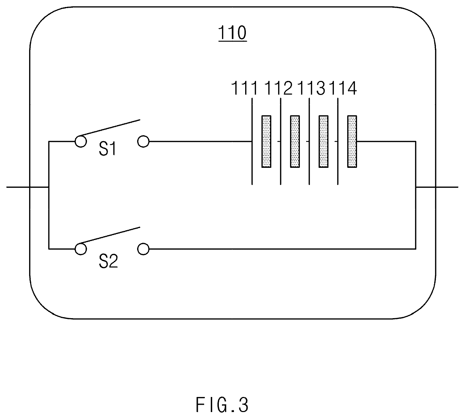

FIG. 3 is a circuit diagram of a battery module according to an embodiment disclosed herein.

For convenience of a description, among the plurality of battery modules 110, 120, 130, ..., 140, the battery module 110 will be described as an example, but the description may be substantially identically applied to the other battery modules 120, 130, ..., 140.

Referring to FIG. 3, the battery module 110 may include a plurality of battery cells 111, 112, 113, and 114. While four battery cells are shown as a plurality of battery cells 111, 112, 113, and 114 in FIG. 3, the present disclosure is not limited thereto. The battery module 110 may include a switch S1 and/or S2 for switching current applied to the plurality of battery cells 111, 112, 113, and 114. However, without being limited thereto, some components may be omitted from the battery module 110 or other general-purpose components may be further included in the battery module 110.

The battery management apparatus 200 may control an operation period of the battery module 110 by controlling the switch S1 and/or S2 of the battery module 110.

According to an embodiment, the battery module 110 may include a charging/discharging line connected to the plurality of battery cells 111, 112, 113, and 114. The battery module 110 may include a first switch S1 for switching connection between the charging/discharging line and the plurality of battery cells 111, 112, 113, and 114. The first switch S1 may be disposed on a charging/discharging line of the battery module 110.

The battery module 110 may include a bypass line not connected to the plurality of battery cells 111, 112, 113, and 114. The bypass line may bypass current flowing through the charging/discharging line. The battery module 110 may include a second switch S2 disposed on the bypass line connected in parallel to the charging/discharging line.

The first switch S1 and/or the second switch S2 may be, but not limited to, at least one of a relay or an FET. The first switch S1 and/or the second switch S2 may be controlled by the battery management apparatus 200. For example, the first switch S1 and/or the second switch S2 may be controlled by the controller 220.

The controller 220 may control charging/discharging of the battery module 110 by controlling the first switch S1 and/or the second switch S2. For example, the controller 220 may control an operation period related to charging/discharging of the battery module 110 by controlling short-circuit and opening of the first switch S1 and/or the second switch S2.

Thus, the battery management apparatus 200 may efficiently manage heat generated from each of the plurality of battery modules 110, 120, 130, ..., 140 by controlling the charging/discharging operation of each of the plurality of battery modules 110, 120, 130, ..., 140. The battery management apparatus 200 may efficiently manage lifetime and performance of the battery pack 1000 through efficient heat management of the battery pack 1000.

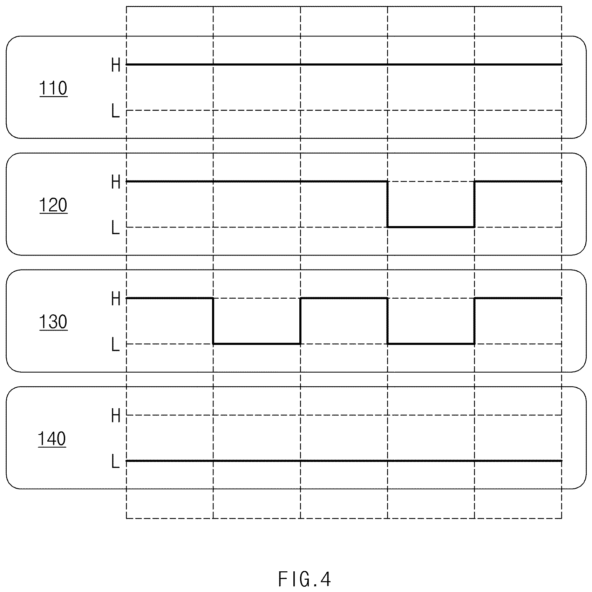

FIG. 4 is a graph showing an operation of a battery module according to an embodiment disclosed herein.

According to an embodiment, operations of the plurality of battery modules 110, 120, 130, ..., 140 shown in FIG. 4 may be understood by referring to the circuit diagram of the battery module 110 shown in FIG. 3.

Referring to FIG. 4, an operation of each of the plurality of battery modules 110, 120, 130, ..., 140 may be expressed in the form of a pulse width modulation (PWM) graph. In the graph, 'H' may indicate a logic high or on state, and 'L' may indicate a logic low or off state.

The plurality of battery modules 110, 120, 130, ..., 140 may operate during a first period as shown in FIG. 4. When the battery module 120 as an example of the plurality of battery modules 110, 120, 130, ..., 140 is in a logic high (H) state, the battery module 120 may be in an activated state. When the battery module 120 is in a logic low (L) state, the battery module 120 may be in a deactivated state. In the graph of FIG. 4, the battery module 120 may have an activation rate of 80 % during the first period.

The plurality of battery modules 110, 120, 130, ..., 140 may have different activation rates. According to an embodiment, the activation rate of the battery module 110 may be 100 %, the activation rate of the battery module 120 may be 80 %, the activation rate of the battery module 130 may be 60 %, and the activation rate of the battery module 140 may be 0 %, but the present disclosure is not limited thereto.

When the battery module 110 is in the logic high (H) state during the first period, the activation rate of the battery module 110 may be 100 %. That is, when the activation rate is 100 %, the battery module 110 may be in a constantly operating state. For example, when the activation rate of the battery module 110 is 100 % in a charging state, the battery module 110 may be in a constantly charged state. For example, when the activation rate of the battery module 110 is 100 % in a discharging state, the battery module 110 may be in a constantly discharged state.

According to an embodiment, when the activation rate of the battery module 110 is 100 %, the first switch S1 of the battery module 110 may be short-circuited and the second switch S2 may be opened in the charging state and the discharging state.

According to an embodiment, when the battery modules 120 and 130 include both the logic high (H) state and the logic low (L) state during the first period, the activation rate of the battery modules 120 and 130 may be greater than 0 and less than 100.

When the activation rate of the battery module 120 is 80 % during the first period, the battery module 120 may in an operating state during 80 % of the first period and in a non-operating state during 20 % of the first period. For example, when the activation rate of the battery module 120 is 80 % in a charging state, the battery module 120 may be charged up to 80 % of a charging amount of the battery module 110. For example, when the activation rate of the battery module 120 is 80 % in a discharging state, the battery module 120 may be discharged up to 80 % of a discharging amount of the battery module 110.

According to an embodiment, when the activation rate of the battery module 120 is 80 %, in the charging state and the discharging state, the first switch S1 of the battery module 120 may be short-circuited and the second switch S2 may be opened during 80 % of the first period, and the first switch S1 may be opened and the second switch S2 may be short-circuited during the remaining time of the first period.

According to an embodiment, when the activation rate of the battery module 130 is 60 % during the first period, the battery module 130 may in an operating state during 60 % of the first period and in a non-operating state during 40 % of the first period. In this case, the battery module 130 may operate identically to as when the battery module 110 is activated only during 60 % of the first period. A description related to an operation of the battery module 130 may be understood from the above-described embodiment of the battery module 120, and thus will not be repeatedly provided.

According to an embodiment, when the battery module 140 is in the logic low (L) state during the first period, the battery module 140 may be in the deactivated state during the first period. When the battery module 140 is in the deactivated state during the first period, the activation rate of the battery module 140 may be 0 %. When the activation rate is 0 %, the battery module 140 may be in a state of not operating constantly. For example, when the activation rate of the battery module 140 is 0 % in a charging state, charging of the battery module 140 may be stopped. For example, when the activation rate of the battery module 140 is 0 % in a discharging state, the battery module 140 may be in a discharging-stopped state.

According to an embodiment, for an activation rate of 0 %, the first switch S1 of the battery module 140 may be opened and the second switch S2 may be short-circuited in the charging state and the discharging state.

The battery management apparatus 200 may control an operation period of each of the plurality of battery modules 110, 120, 130, ..., 140 by controlling the activation rate of each of the plurality of battery modules 110, 120, 130, ..., 140. Thus, the battery management apparatus 200 may efficiently manage heat generated from each of the plurality of battery modules 110, 120, 130, ..., 140. The battery management apparatus 200 may efficiently manage lifetime and performance of the battery pack 1000 through efficient heat management of the battery pack 1000.

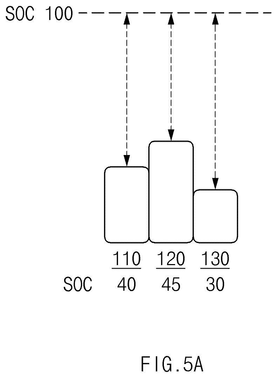

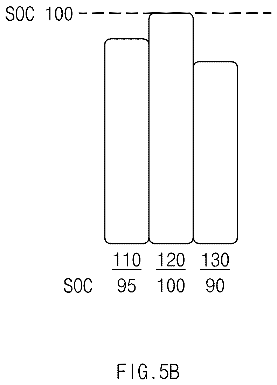

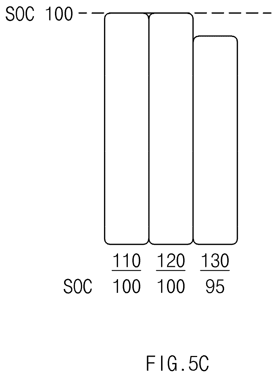

FIG. 5A is a graph showing an SOC of a battery module at first time of a charging operation, according to an embodiment disclosed herein. FIG. 5B is a graph showing an SOC of a battery module in a second time of a charging operation, according to an embodiment disclosed herein. FIG. 5C is a graph showing an SOC of a battery module in a third time of a charging operation, according to an embodiment disclosed herein.

According to an embodiment, operations of the plurality of battery modules 110, 120, and 130 shown in FIGS. 5A, 5B, and 5C may be understood by referring to the circuit diagram of the battery module 110 shown in FIG. 3.

FIG. 5A is a graph showing an SOC of each of the plurality of battery modules 110, 120, and 130 at the first time of a charging operation. The first time of the charging operation may be a point in time at which charging starts.

Referring to FIG. 5A, in an initial charging state, SOCs of the plurality of battery modules 110, 120, and 130 may be different from each other. According to an embodiment, the SOC of the battery module 110 may be 40, the SOC of the battery module 120 may be 45, and the SOC of the battery module 130 may be 30. The battery management apparatus 200 may initiate charging of the plurality of battery modules 110, 120, and 130.

FIG. 5B is a graph showing an SOC of each of the plurality of battery modules 110, 120, and 130 when the plurality of battery modules 110, 120, and 130 are charged during the second time.

Referring to FIG. 5B, when the plurality of battery modules 110, 120, and 130 are charged during the second time, the SOC of the battery module 120 may reach a charging end SOC. For example, the charging end SOC may be an SOC in which charging of each of the plurality of battery modules 110, 120, and 130 may be completed. The battery management apparatus 200 may stop charging of the battery module 120 reaching the charging end SOC. The battery management apparatus 200 may control current not to flow through a charging/discharging line of the plurality of battery cells 111, 112, 113, ..., 114 (see FIG. 3) included in the battery module 120 and current to flow through the bypass line. According to an embodiment, the controller 220 may control the first switch S1 of the battery module 120 reaching the charging end SOC to be opened and the second switch S2 to be short-circuited, so as to stop charging of the battery module 120.

The battery management apparatus 200 may uniformly charge the plurality of battery modules 110, 120, and 130 by stopping charging of the battery module 120 reaching the charging end SOC. The battery management apparatus 200 may efficiently perform heat management of the battery pack 1000 by controlling charging of each of the plurality of battery modules 110, 120, and 130.

FIG. 5C is a graph showing an SOC of each of the plurality of battery modules 110, 120, and 130 when the plurality of battery modules 110, 120, and 130 are charged during the third time.

Referring to FIG. 5C, when the plurality of battery modules 110, 120, and 130 are charged during the third time, the SOC of the battery module 110 may reach the charging end SOC. The battery management apparatus 200 may stop charging of the battery module 110 reaching the charging end SOC. The battery management apparatus 200 may control current not to flow through a charging/discharging line of the plurality of battery cells 111, 112, 113, ..., 114 included in the battery module 110 and current to flow through the bypass line. According to an embodiment, the controller 220 may control the first switch S1 of the battery module 110 reaching the charging end SOC to be opened and the second switch S2 to be short-circuited.

The battery management apparatus 200 may uniformly charge the plurality of battery modules 110, 120, and 130 by stopping charging of the battery modules 110 and 120 reaching the charging end SOC. The battery management apparatus 200 may perform heat management of the battery pack 1000 by controlling charging of each of the plurality of battery modules 110, 120, and 130. In this way, the battery management apparatus 200 may efficiently manage lifetime and performance of the battery pack 1000.

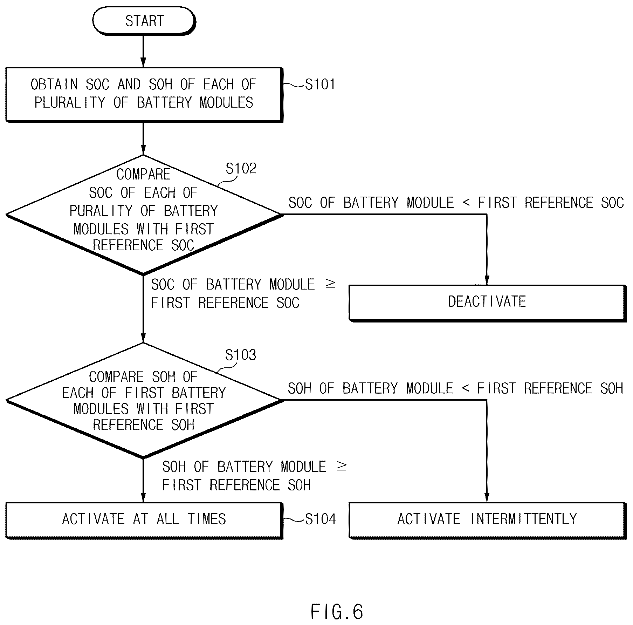

FIG. 6 is a flowchart of a discharging operation of a battery management apparatus according to an embodiment disclosed herein.

Operations shown in FIG. 6 may be performed by the battery management apparatus 200 of FIG. 2.

Referring to FIG. 6, in operation S101, the obtaining unit 210 may obtain an SOC and/or an SOH of each of the plurality of battery modules 110, 120, 130, 140, 150, 160, and 170.

In operation S102, the controller 220 may compare the SOC of each of the plurality of battery modules 110, 120, 130, 140, 150, 160, and 170 with a first reference SOC. The controller 220 may determine a battery module having an SOC greater than the first reference SOC (e.g., the battery modules 110, 120, 130, 140, 150, 160, and 170) as at least one first battery module.

Herein, the first reference SOC may be determined as a lower value among SOCs of the plurality of battery modules 110, 120, 130, 140, 150, 160, and 170. According to an embodiment, the controller 220 may determine the first reference SOC based on an average and a standard deviation of the SOCs of the plurality of battery modules 110, 120, 130, 140, 150, 160, and 170. According to an embodiment, the first reference SOC may be determined by [Equation 1].

First Reference SOC = (Average of SOCs of plurality of battery modules) - 1.5 x (Standard deviation of SOCs of plurality of battery modules)   [Equation 1]

Thus, the controller 220 may classify each of the plurality of battery modules 110, 120, 130, 140, 150, 160, and 170, based on the first reference SOC.

The controller 220 may determine the battery module 150 having an SOC less than the first reference SOC as at least one third battery module. The controller 220 may determine an activation rate of the at least one third battery module 150. According to an embodiment, the controller 220 may control the at least one third battery module 150 having the SOC less than the first reference SOC to be in the deactivated state. For example, the controller 220 may determine the activation rate of the at least one third battery module 150 as 0 %. In this way, the battery module 150 having a low SOC may not be discharged. Thus, the battery management apparatus 200 may perform heat management of the battery pack 1000.

In operation S103, the controller 220 may compare the SOH of each of the at least one first battery modules 110, 120, 130, 140, 160, and 170 with a first reference SOH. The controller 220 may determine the at least one battery module (e.g., 110, 120, and 130) having SOHs less than the first reference SOH as at least one second battery module.

Herein, the first reference SOH may be determined according to a use state of the battery pack 1000. The controller 220 may determine the first reference SOH based on the SOH of the battery pack 1000. According to an embodiment, the controller 220 may determine the first reference SOH based on the SOH corresponding to a use year of the battery pack 1000 and/or a discharging cycle number of the battery pack 1000. The controller 220 may determine a less SOH between the SOH corresponding to the use year and/or the SOH corresponding to the discharging cycle number as the first reference SOH. According to an embodiment, the first reference SOH may be determined by [Equation 2].

$$\text{First Reference SOH} = \min(\text{SOH corresponding to use year, SOH corresponding to discharging cycle number}) \qquad \text{[Equation 2]}$$

Thus, the controller 220 may classify each of the at least one first battery modules 110, 120, 130, 140, 160, and 170, based on the first reference SOH.

In operation S104, the controller 220 may determine the activation rate of each of the at least one first battery modules 110, 120, 130, 140, 160, and 170. In another aspect, the controller 220 may determine the operation period based on the SOH of each of the first battery modules 110, 120, 130, 140, 160, and 170.

The controller 220 may control the battery modules 140, 160, and 170 having SOHs greater than or equal to the first reference SOH among the at least one first battery modules 110, 120, 130, 140, 160, and 170 to be activated at all times. For example, the controller 220 may determine the activation rate of the battery modules 140, 160, and 170 as 100 %.

The controller 220 may control the at least one second battery modules (e.g., 110, 120, and 130) having SOHs less than the first reference SOH among the at least one first battery modules 110, 120, 130, 140, 160, and 170 to be activated intermittently. For example, the controller 220 may determine the activation rate of the second battery modules 110, 120, and 130 as a value between 0 % and 100 %.

Thus, the battery management apparatus 200 may determine the activation rate of each of the at least one first battery modules 110, 120, 130, 140, 160, and 170 to control a discharging operation of each of them. In this way, the battery modules 140, 160, and 170 having high SOHs may be discharged at all times, and the battery modules 110, 120, and 130 having low SOHs may be discharged intermittently. Thus, the battery management apparatus 200 may manage heat generated from the battery modules 110, 120, and 130 having low SOHs and much heat emission, by controlling operations of the battery modules 110, 120, and 130 having low SOHs to be less than operations of the battery modules 140, 160, and 170 having high SOHs.

The battery management apparatus 200 may also optimize performance of the battery modules 110, 120, and 130 having low SOHs to lengthen lifetime thereof, by reducing the operations of the battery modules 110, 120, and 130 having low SOHs and much heat emission. In this way, the battery management apparatus 200 may control a total amount of heat generated from each of the first battery modules 110, 120, 130, 140, 160, and 170. Moreover, the battery management apparatus 200 may perform heat management of the battery pack 1000.

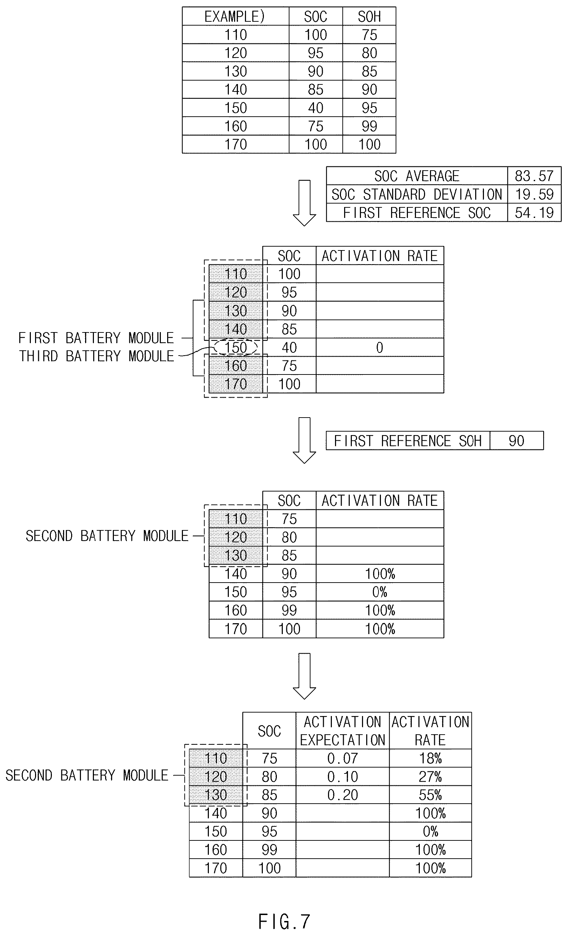

FIG. 7 is a chart showing an activation rate determining process of a battery management apparatus, according to an embodiment disclosed herein.

According to an embodiment, the plurality of battery modules 110, 120, 130, ..., 170 shown in FIG. 7 may be understood by referring to operations of the battery management apparatus 200 shown in FIG. 2 and the battery module shown in FIG. 4, and the flowchart of the discharging operation shown in FIG. 6.

Referring to FIG. 7, the obtaining unit 210 may obtain an SOC and an SOH of each of the plurality of battery modules 110, 120, 130, 140, 150, 160, and 170.

According to an embodiment, the controller 220 may determine the at least one first battery modules 110, 120, 130, 140, 160, and 170 among the plurality of battery modules 110, 120, 130, 140, 150, 160, and 170, based on the first reference SOC.

According to an embodiment, the controller 220 may calculate the first reference SOC based on [Equation 1]. For example, the controller 220 may determine the first reference SOC of the plurality of battery modules 110, 120, 130, 140, 150, 160, and 170 as 54.19, based on an average (83.57) and a standard deviation (19.59) of the SOCs.

According to an embodiment, the controller 220 may compare the SOC of each of the plurality of battery modules 110, 120, 130, 140, 150, 160, and 170 with a first reference SOC. The controller 220 may determine a battery module having an SOC greater than or equal to the first reference SOC, i.e., 54.19 (e.g., the battery modules 110, 120, 130, 140, 160, and 170) as at least one first battery module.

The controller 220 may determine the battery module 150 having an SOC less than the first reference SOC, i.e., 54.19, as at least one third battery module. The controller 220 may determine the activation rate of the at least one third battery module 150 as 0 %. Thus, the controller 220 may control the at least one third battery module 150 to be in the deactivated state in the discharging operation.

According to an embodiment, the controller 220 may determine the activation rate of each of the at least one first battery modules 110, 120, 130, 140, 160, and 170, based on the first reference SOH.

According to an embodiment, the controller 220 may determine the first reference SOH based on [Equation 2]. For example, the SOH corresponding to the use year of the battery pack 1000 may be 92, and the SOH corresponding to the discharging cycle number of the battery pack 1000 may be 90. The controller 220 may determine the less SOH between the use year and the discharging cycle number, i.e., 90, as the first reference SOH.

According to an embodiment, the controller 220 may compare the SOH of each of the at least one first battery modules 110, 120, 130, 140, 160, and 170 with the first reference SOH.

The controller 220 may determine the activation rate of the at least one battery module (e.g., 140, 160, and 170) having SOHs greater than or equal to the first reference SOH. According to an embodiment, the controller 220 may determine the activation rate of the battery modules 140, 160, and 170 as 100 %. Thus, the controller 220 may control the battery modules 140, 160, and 170 to be activated at all times in the discharging operation.

The controller 220 may determine the at least one battery module (e.g., 110, 120, and 130) having SOHs less than the first reference SOH as at least one second battery module. The controller 220 may determine the activation rate of the at least one second battery modules 110, 120, and 130. According to an embodiment, the controller 220 may determine that a sum of the activation rates of the at least one second battery modules 110, 120, and 130 is equal to the activation rate of one of the battery modules 140, 160, and 170 having the SOHs greater than the first reference SOH. For example, the controller 220 may determine that a sum of the activation rates of the at least one second battery modules 110, 120, and 130 is equal to the activation rate of the battery module 140. In this case, the controller 220 may determine that a sum of the activation rate of the battery module 110, the activation rate of the battery module 120, and the activation rate of the battery module 120 is 100 %.

The controller 220 may determine an activation expectation of each of the at least one second battery modules 110, 120, and 130.

The activation rate may be determined based on an activation expectation. According to an embodiment, the activation expectation may be determined by the first reference SOH and the SOH of the module. According to an embodiment, the activation expectation may be determined by [Equation 3].

[Equation 3]

$$\text{Activation Expectation} = 1/(\text{First reference SOH} - \text{Module SOH})$$

According to an embodiment, the controller 220 may determine the activation expectation of each of the at least one second battery modules 110, 120, and 130, based on a value obtained by subtracting the SOH of each of the at least one second battery modules 110, 120, and 130 from the first reference SOH, i.e., 90. For example, the controller may determine that the activation expectation of the battery module 110 is 0.07, the activation expectation of the battery module 120 is 0.10, and the activation expectation of the battery module 130 is 0.20.

According to an embodiment, the controller 220 may determine the activation rate of each of the at least one second battery modules 110, 120, and 130, based on the activation expectation of each of the at least one second battery modules 110, 120, and 130. According to an embodiment, the controller 220 may determine a percentage of the activation expectation as the activation rate.

According to an embodiment, the controller 220 may control the discharging operation of each of the at least one second battery modules 110, 120, and 130, based on the activation rate of each of the at least one second battery modules 110, 120, and 130. The controller 220 may control the operation period of each of the at least one second battery modules 110, 120, and 130, based on the activation rate in the discharging state. A matter related to control of the operation period of each of the at least one second battery modules 110, 120, and 130 based on the activation rate may be the same as a matter described with reference to FIG. 4.

The battery management apparatus 200 may control the operations of the plurality of battery modules 110, 120, 130, 140, 150, 160, and 170 according to the activation rate of each of the plurality of battery modules 110, 120, 130, 140, 150, 160, and 170. In this way, by managing the operation period of each of the plurality of battery modules 110, 120, 130, 140, 150, 160, and 170 in the discharging state, module balancing may be achieved. Moreover, lifetime and performance of each of the plurality of battery modules 110, 120, 130, 140, 150, 160, and 170 having different SOCs and/or SOHs may be effectively managed. Moreover, the battery management apparatus 200 may perform heat management of the battery pack 1000.

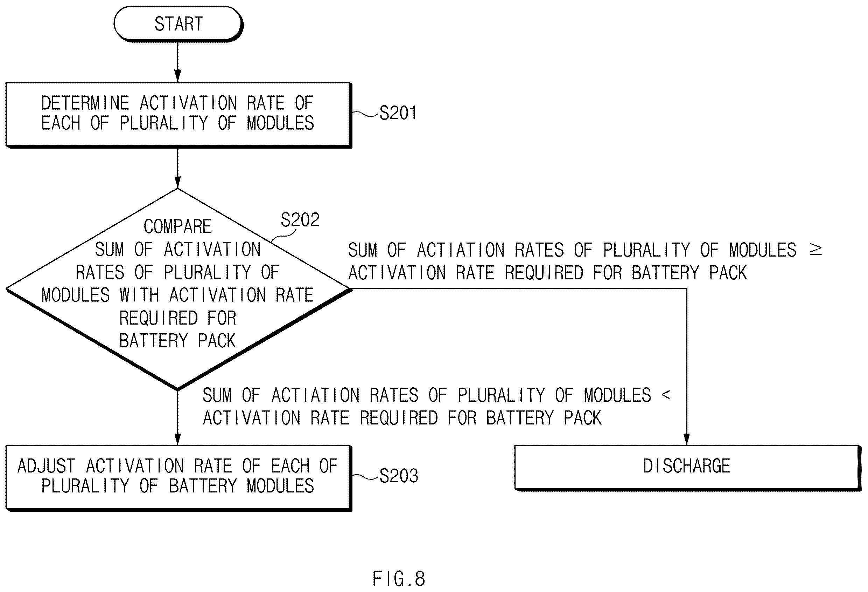

FIG. 8 is a flowchart of a discharging operation of a battery management apparatus, according to an embodiment disclosed herein.

Operations shown in FIG. 8 may be performed by the battery management apparatus 200 of FIG. 2.

Referring to FIG. 8, in operation S201, the controller 220 may determine the activation rate of each of the plurality of battery modules 110, 120, 130, 140, 150, 160, and 170. A matter related to determination of the activation rate may be understood by referring to the flowchart of the discharging operation of the battery management apparatus 200 of FIG. 6 and the chart showing the activation rate determining process of the battery management apparatus 200 of FIG. 7.

In operation S202, the controller 220 may compare a sum of the activation rate of each of the plurality of battery modules 110, 120, 130, 140, 150, 160, and 170 with a predetermined activation rate that is an activation rate required for the battery pack 1000.

The controller 220 may determine the activation rate required to the minimum for an operation of the battery pack 1000 as the predetermined activation rate. According to an embodiment, when a minimum module number for the operation of the battery pack 1000 is 5, the activation rate required for the battery pack may be 500 %.

According to an embodiment, the controller 220 may start discharging of the battery pack 1000 when the sum of the activation rate of each of the plurality of battery modules 110, 120, 130, 140, 150, 160, and 170 is greater than or equal to the predetermined activation rate required for the battery pack 1000.

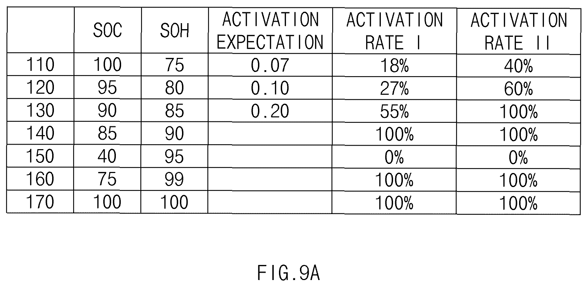

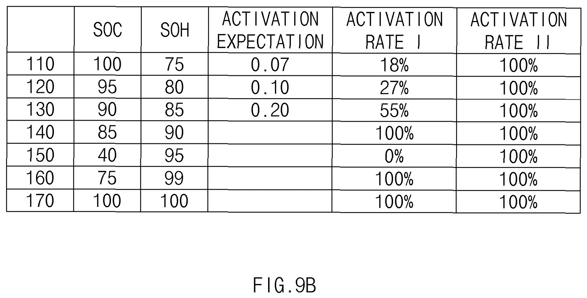

In operation S203, the controller 220 may adjust the activation rate of each of the plurality of battery modules 110, 120, 130, 140, 150, 160, and 170 when the sum of the activation rate of each of the plurality of battery modules 110, 120, 130, 140, 150, 160, and 170 is less than the predetermined activation rate required for the battery pack 1000. The controller 220 may increase the activation rate of the module not having the activation rate of 100 % among the plurality of battery modules 110, 120, 130, 140, 150, 160, and 170. An embodiment related to the activation rate may be described with reference to FIGS. 9A and 9B.

The controller 220 may control the battery pack 1000 to be in an operating state by adjusting the activation rate. By adjusting the activation rate, the battery management apparatus 200 may satisfy a lower limit of a minimum module activation rate for operating the battery pack 1000. Thus, the battery management apparatus 200 may efficiently manage the plurality of battery modules 110, 120, 130, 140, 150, 160, and 170. The operation of the battery pack 1000 may be managed stably.

FIG. 9A is a chart showing an activation rate determining process of a battery management apparatus, according to another embodiment disclosed herein, and FIG. 9B is a chart showing an activation rate determining process of a battery management apparatus, according to yet another embodiment disclosed herein.

Operations shown in FIGS. 9A and 9B may be performed by the battery management apparatus 200 of FIG. 2. The operations of FIGS. 9A and 9B may be understood by referring to FIGS. 6, 7, and 8.

Referring to FIG. 9A, the controller 220 may adjust the activation rate of each of the plurality of battery modules 110, 120, 130, 140, 150, 160, and 170.

At present, the sum of the activation rate of each of the plurality of battery modules 110, 120, 130, 140, 150, 160, and 170 may be 400 % (400 = 18 + 27 + 55 + 100 + 100 + 100).

According to an embodiment, the activation rate required for the operation of the battery pack 1000 may be 500 %.

When the sum of the activation rates of the plurality of battery modules 110, 120, 130, 140, 150, 160, and 170 is less than the activation rate required for the battery pack 1000, the controller 220 may adjust the activation rate of the module having an activation rate being less than 100 %. According to an embodiment, the controller 220 may sequentially adjust the activation rate by considering the SOC and the SOH of each of the plurality of battery modules 110, 120, 130, 140, 150, 160, and 170.

According to an embodiment, the controller 220 may adjust the activation rate of the module having the activation rate being greater than 0 % and less than 100 %. For example, the controller 220 may adjust the activation rate of the at least one second battery modules 110, 120, and 130. According to an embodiment, the controller 220 may adjust the activation rates of the second battery modules 110, 120, and 130 greater than 0 % and less than 100 % before the battery module 150 having the activation rate of 0 %. Thus, the controller 220 may increase the activation rates of the at least one second battery modules 110, 120, and 130 to adjust a sum of the activation rate of each of the plurality of battery modules 110, 120, 130, 140, 150, 160, and 170 to be greater than or equal to the activation rate required for the battery pack.

In this way, the controller 220 may control the second battery modules 110, 120, and 130 having high SOCs to operate at the higher activation rate than the battery module 150 having a low SOC. Thus, the battery management apparatus 200 may efficiently manage the plurality of battery modules 110, 120, 130, 140, 150, 160, and 170. Moreover, the battery management apparatus 200 may stably manage the operation of the battery pack 1000.

Referring to FIG. 9B, the controller 220 may adjust the activation rate of each of the plurality of battery modules 110, 120, 130, 140, 150, 160, and 170.

At present, the sum of the activation rate of each of the plurality of battery modules 110, 120, 130, 140, 150, 160, and 170 may be 400 % (400 = 18 + 27 + 55 + 100 + 100 + 100).

According to an embodiment, the activation rate required for the operation of the battery pack 1000 may be 700 %.

When the sum of the activation rates of the plurality of battery modules 110, 120, 130, 140, 150, 160, and 170 is less than the activation rate required for the battery pack 1000, the controller 220 may adjust the activation rate of the module having an activation rate being less than 100 %. The controller 220 may adjust the sum of the activation rate of each of the plurality of battery modules 110, 120, 130, 140, 150, 160, and 170 to be greater than or equal to the activation rate required for the battery pack.

The controller 220 may sequentially adjust the activation rate by considering the SOC and the SOH of each of the plurality of battery modules 110, 120, 130, 140, 150, 160, and 170. According to an embodiment, the controller 220 may first adjust the activation rates of the battery modules 110, 120, and 130 having the activation rates being greater than 0 % and less than 100 %. Next, the controller 220 may adjust the activation rate of the at least one battery module 150 having an activation rate of 0.

Through the management method of the battery management apparatus 200, the battery management apparatus 200 may manage each of the plurality of battery modules 110, 120, 130, 140, 150, 160, and 170 by considering the SOC and the SOH of each of the plurality of battery modules 110, 120, 130, 140, 150, 160, and 170. Moreover, through the management method of the battery management apparatus 200, the battery pack 1000 may be managed to stably operate.

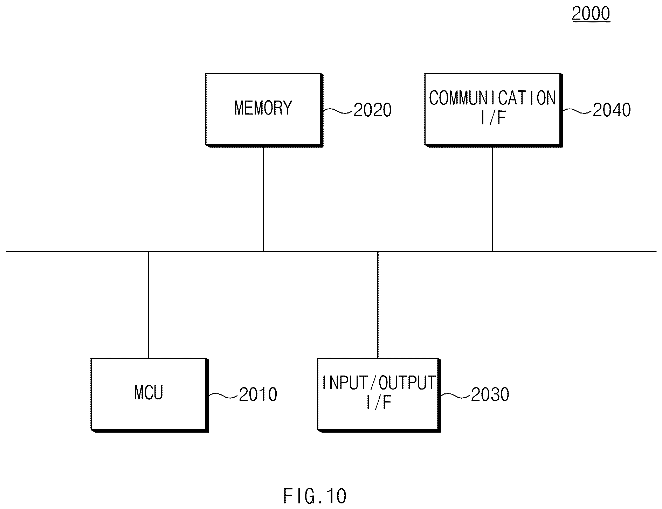

FIG. 10 is a block diagram showing a hardware configuration of a computing system for performing an operating method of a battery management apparatus, according to an embodiment disclosed herein.

Referring to FIG. 10, a computing system 2000 according to an embodiment disclosed herein may include an MCU 2010, a memory 2020, an input/output I/F 2030, and a communication I/F 2040.

The MCU 2010 may be a processor that executes various programs (e.g., a battery cell feature data collection program, a latent variable extraction program, a distribution generation program, a battery cell diagnosis program, etc.) stored in the memory 2020, processes various information including feature data, latent variables, etc., of the battery cell through these programs, and executes the above-described functions of the controller 220 included in the battery management apparatus 200 shown in FIGS. 1 to 9.

The memory 2020 may store various programs such as a battery cell feature data collection program, a latent variable extraction program, a distribution generation program, a battery cell diagnosis program, etc. Moreover, the memory 2020 may store various information such as feature data, a latent variable, etc., of the battery cell.

The memory 2020 may be provided in plural, depending on a need. The memory 2020 may be volatile memory or non-volatile memory. For the memory 2020 as the volatile memory, random access memory (RAM), dynamic RAM (DRAM), static RAM (SRAM), etc., may be used. For the memory 2020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2020 are merely examples and are not limited thereto.

The input/output I/F 2030 may provide an interface for transmitting and receiving data by connecting an input device (not shown) such as a keyboard, a mouse, a touch panel, etc., and an output device such as a display (not shown), etc., to the MCU 2010.

The communication I/F 2040, which is a component capable of transmitting and receiving various data to and from a server, may be various devices capable of supporting wired or wireless communication. For example, the battery management apparatus 200 may transmit and receive various information including SOC, OCV, parameter, etc., of the battery cell to and from an external server separately provided through the communication I/F 2040.

As such, a computer program according to an embodiment disclosed herein may be recorded in the memory 2020 and processed by the MCU 2010, thus being implemented as a module that performs functions shown in FIG. 2.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure and may various changes, substitutions, and modifications may be made herein without departing from the scope of the present disclosure.

## Claims

1. A battery pack comprising:

    a plurality of battery modules; and
    a battery management apparatus configured to:

        obtain a state of charge (SOC) and a state of health (SOH) of each of the plurality of battery modules;
        determine one or more first battery modules based on the SOC of each of the plurality of battery modules; and
        determine an activation rate of each of the first battery modules based on the SOH of each of the first battery modules.

2. The battery pack of claim 1, wherein the battery management apparatus is further configured to compare the SOC of each of the plurality of battery modules with a first reference SOC and determine battery modules having an SOC greater than or equal to the first reference SOC to be the first battery modules.

3. The battery pack of claim 2, wherein the battery management apparatus is further configured to determine the first reference SOC based on an average and a standard deviation of SOCs of the plurality of battery modules.

4. The battery pack of claim 1, wherein the battery management apparatus is further configured to compare the SOH of each of the first battery modules with a first reference SOH and determine one or more second battery modules having an SOH less than the first reference SOH.

5. The battery pack of claim 4, wherein the battery management apparatus is further configured to determine a sum of activation rates of the second battery modules to be equal to an activation rate of one of the first battery modules having an SOH greater than the first reference SOH.

6. The battery pack of claim 4, wherein the battery management apparatus is further configured to determine a minimum SOH between an SOH corresponding to a use year of the battery pack and an SOH corresponding to a discharging cycle number of the battery pack to be the first reference SOH.

7. The battery pack of claim 4, wherein the battery management apparatus is further configured to:

    determine an activation expectation of each of the second battery modules based on the SOH of each of the second battery modules;
    determine an activation rate of each of the second battery modules based on the activation expectation; and
    control an operation period of each of the second battery modules based on the activation rate of each of the second battery modules.

8. The battery pack of claim 1, wherein the battery management apparatus is further configured to compare the SOC of each of the plurality of battery modules with a first reference SOC, determine battery modules having an SOC less than the first reference SOC to be one or more third battery modules, and control the third battery modules to be in a deactivated state.

9. The battery pack of claim 1, wherein the battery management apparatus is further configured to adjust an activation rate of each of the first battery modules, wherein a sum of the activation rate of each of the first battery modules is greater than or equal to a predetermined activation rate for the battery pack.

10. The battery pack of claim 1, wherein each of the plurality of battery modules comprises:

a battery cell;
a first switch disposed on a charging/discharging line of the battery cell; and
a second switch disposed on a bypass line connected in parallel to the charging/discharging line, and
the battery management apparatus is further configured to control an operation period of each of the at least one first battery modules by controlling the first switch and the second switch according to the activation rate.

11. A management method of a battery pack, the management method comprising:

obtaining a state of charge (SOC) and a state of health (SOH) of each of the plurality of battery modules;
determining one or more first battery modules based on the SOC of each of the plurality of battery modules; and
determining an activation rate of each of the first battery modules based on the SOH of each of the first battery modules.

12. The management method of claim 11, wherein determining of the at least one first battery modules comprises:

comparing the SOC of each of the plurality of battery modules with a first reference SOC; and
determining battery modules having an SOC greater than or equal to the first reference SOC to be the first battery modules.

13. The management method of claim 12, wherein determining the first battery modules comprises determining the first reference SOC based on an average and a standard deviation of SOCs of the plurality of battery modules.

14. The management method of claim 11, wherein determining the activation rate of each of the first battery modules comprises:

comparing the SOHs of the first battery modules with a first reference SOH; and
determining one or more second battery modules having an SOH less than the first reference SOH.

15. The management method of claim 14, wherein determining the activation rate of each of the first battery modules comprises determining a sum of activation rates of the second battery modules to be equal to an activation rate of one of the first battery modules having an SOH greater than the first reference SOH.

16. The management method of claim 14, wherein determining the second battery modules comprises determining a minimum SOH between an SOH corresponding to a use year of the battery pack and an SOH corresponding to a discharging cycle number of the battery pack to be the first reference SOH.

17. The management method of claim 14, further comprising:

determining an activation expectation of each of the second battery modules based on the SOH of each of the second battery modules;
determining an activation rate of each of the second battery modules based on the activation expectation; and
controlling an operation period of each of the second battery modules based on the activation rate of each of the second battery modules.

18. The management method of claim 11, further comprising:

comparing the SOC of each of the plurality of battery modules with a first reference SOC;
determining battery modules having an SOC less than the first reference SOC to be third battery modules; and
controlling the third battery modules to be in a deactivated state.

19. The management method of claim 11, further comprising adjusting an activation rate of each of the first battery modules, wherein a sum of the activation rate of each of the first battery modules is greater than or equal to a predetermined activation rate for the battery pack.

20. The management method of claim 11, further comprising controlling an operation period of each of the first battery modules by controlling, according to the activation rate, a first switch disposed on a charging/discharging line of the battery cell included in each of the plurality of battery modules and a second switch disposed on a bypass line connected in parallel to the charging/discharging line.

BATTERY PACK
1000

| BATTERY MODULE 110 | BATTERY MODULE 120 | BATTERY MODULE 130 | BATTERY MODULE 140 | BATTERY MANAGEMENT APPARATUS 200 |

FIG.1

200

| OBTAINING UNIT 210 | CONTROLLER 220 |
|---|---|

FIG.2

FIG.3

FIG.4

SOC 100

|  | 110 | 120 | 130 |
|---|---|---|---|
| SOC | 40 | 45 | 30 |

FIG.5A

SOC 100 – – – – – – – – – – – – – –

|  | 110 | 120 | 130 |
|---|---|---|---|
| SOC | 95 | 100 | 90 |

FIG.5B

SOC 100 — — — — — — — — — — —

|           | 110 | 120 | 130 |
|-----------|-----|-----|-----|
| SOC       | 100 | 100 | 95  |

FIG.5C

```
                            ┌─────────────┐
                            │    START    │
                            └──────┬──────┘
                                   │
                                   ▼
              ┌──────────────────────────────────────┐
              │  OBTAIN SOC AND SOH OF EACH OF         │~S101
              │  PLURALITY OF BATTERY MODULES          │
              └──────────────────┬───────────────────┘
                                 │
                                 ▼
                         ◇ COMPARE        S102
                    ◇      SOC OF EACH OF      ◇   SOC OF BATTERY MODULE < FIRST REFERENCE SOC
                ◇        PURALITY OF BATTERY     ◇──────────────────────────────────────┐
                    ◇     MODULES WITH FIRST   ◇                                         │
                         ◇    REFERENCE SOC ◇                                            │
                                 │                                                       │
                   SOC OF BATTERY MODULE ≥                                               ▼
                      FIRST REFERENCE SOC                              ┌──────────────────────────────┐
                                 │                                     │          DEACTIVATE          │
                                 ▼                                     └──────────────────────────────┘
                         ◇ COMPARE SOH OF   S103
                    ◇      EACH OF FIRST BATTERY  ◇  SOH OF BATTERY MODULE < FIRST REFERENCE SOH
                ◇        MODULES WITH FIRST      ◇──────────────────────────────────────┐
                    ◇      REFERENCE SOH   ◇                                             │
                                 │                                                       │
                   SOH OF BATTERY MODULE ≥                                               ▼
                      FIRST REFERENCE SOH                              ┌──────────────────────────────┐
                                 ▼                                     │     ACTIVATE INTERMITTENTLY   │
              ┌──────────────────────────────┐                        └──────────────────────────────┘
              │     ACTIVATE AT ALL TIMES     │~S104
              └──────────────────────────────┘
```

FIG.6

| EXAMPLE) | SOC | SOH |
|---|---|---|
| 110 | 100 | 75 |
| 120 | 95 | 80 |
| 130 | 90 | 85 |
| 140 | 85 | 90 |
| 150 | 40 | 95 |
| 160 | 75 | 99 |
| 170 | 100 | 100 |

| | |
|---|---|
| SOC AVERAGE | 83.57 |
| SOC STANDARD DEVIATION | 19.59 |
| FIRST REFERENCE SOC | 54.19 |

| | SOC | ACTIVATION RATE |
|---|---|---|
| 110 | 100 | |
| 120 | 95 | |
| 130 | 90 | |
| 140 | 85 | |
| 150 | 40 | 0 |
| 160 | 75 | |
| 170 | 100 | |

FIRST BATTERY MODULE
THIRD BATTERY MODULE

| | |
|---|---|
| FIRST REFERENCE SOH | 90 |

| | SOC | ACTIVATION RATE |
|---|---|---|
| 110 | 75 | |
| 120 | 80 | |
| 130 | 85 | |
| 140 | 90 | 100% |
| 150 | 95 | 0% |
| 160 | 99 | 100% |
| 170 | 100 | 100% |

SECOND BATTERY MODULE

| | SOC | ACTIVATION EXPECTATION | ACTIVATION RATE |
|---|---|---|---|
| 110 | 75 | 0.07 | 18% |
| 120 | 80 | 0.10 | 27% |
| 130 | 85 | 0.20 | 55% |
| 140 | 90 | | 100% |
| 150 | 95 | | 0% |
| 160 | 99 | | 100% |
| 170 | 100 | | 100% |

SECOND BATTERY MODULE

FIG.7

23

```
                    ┌─────────────┐
                    │    START    │
                    └──────┬──────┘
                           │
                           ▼
        ┌──────────────────────────────────┐
        │ DETERMINE ACTIVATION RATE OF      │──── S201
        │ EACH OF PLURALITY OF MODULES      │
        └──────────────────┬───────────────┘
                           │
                           ▼
                      ╱─────────╲   S202
                    ╱  COMPARE    ╲        SUM OF ACTIATION RATES OF PLURALITY OF MODULES ≥
                  ╱ SUM OF ACTIVATION ╲     ACTIVATION RATE REQUIRED FOR BATTERY PACK
                 ╱ RATES OF PLURALITY OF ╲
                ╱ MODULES WITH ACTIVATION RATE ╲─────────────────────────────┐
                ╲    REQUIRED FOR            ╱                                │
                 ╲    BATTERY PACK         ╱                                  │
                  ╲                      ╱                                    │
                    ╲─────────┬────────╱                                     │
                              │  SUM OF ACTIATION RATES OF PLURALITY OF MODULES < │
                              │  ACTIVATION RATE REQUIRED FOR BATTERY PACK        │
                              ▼                                              ▼
        ┌──────────────────────────────────┐          ┌─────────────────────────────┐
        │ ADJUST ACTIVATION RATE OF EACH OF │── S203   │        DISCHARGE            │
        │ PLURALITY OF BATTERY MODULES      │          └─────────────────────────────┘
        └──────────────────────────────────┘
```

FIG.8

| | SOC | SOH | ACTIVATION EXPECTATION | ACTIVATION RATE I | ACTIVATION RATE II |
|---|---|---|---|---|---|
| 110 | 100 | 75 | 0.07 | 18% | 40% |
| 120 | 95 | 80 | 0.10 | 27% | 60% |
| 130 | 90 | 85 | 0.20 | 55% | 100% |
| 140 | 85 | 90 | | 100% | 100% |
| 150 | 40 | 95 | | 0% | 0% |
| 160 | 75 | 99 | | 100% | 100% |
| 170 | 100 | 100 | | 100% | 100% |

FIG.9A

| | SOC | SOH | ACTIVATION EXPECTATION | ACTIVATION RATE I | ACTIVATION RATE II |
|---|---|---|---|---|---|
| 110 | 100 | 75 | 0.07 | 18% | 100% |
| 120 | 95 | 80 | 0.10 | 27% | 100% |
| 130 | 90 | 85 | 0.20 | 55% | 100% |
| 140 | 85 | 90 | | 100% | 100% |
| 150 | 40 | 95 | | 0% | 100% |
| 160 | 75 | 99 | | 100% | 100% |
| 170 | 100 | 100 | | 100% | 100% |

FIG.9B

2000

MEMORY ⁓2020

COMMUNICATION I/F ⁓2040

MCU ⁓2010

INPUT/OUTPUT I/F ⁓2030

FIG.10

## INTERNATIONAL SEARCH REPORT

| International application No. |
| --- |
| **PCT/KR2024/009663** |

| | |
| --- | --- |
| **A. CLASSIFICATION OF SUBJECT MATTER** | |

**G01R 31/396**(2019.01)i; **G01R 31/382**(2019.01)i; **G01R 31/392**(2019.01)i; **G01R 31/36**(2006.01)i; **H01M 10/48**(2006.01)i; **H01M 10/0525**(2010.01)i

According to International Patent Classification (IPC) or to both national classification and IPC

| | |
| --- | --- |
| **B. FIELDS SEARCHED** | |

Minimum documentation searched (classification system followed by classification symbols)

G01R 31/396(2019.01); B60L 11/18(2006.01); B60L 50/50(2019.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 모듈(battery module), SOC, SOH, 활성화 비율(activation ratio), 배터리 관리장치(battery management device), 배터리 팩(battery pack)

| | |
| --- | --- |
| **C. DOCUMENTS CONSIDERED TO BE RELEVANT** | |

| Category* | Citation of document, with indication, where appropriate, of the relevant passages | Relevant to claim No. |
| --- | --- | --- |
| A | KR 10-2019-0023295 A (SAMSUNG ELECTRONICS CO., LTD.) 08 March 2019 (2019-03-08)<br>See paragraphs [0036]-[0150] and claim 12. | 1-20 |
| A | KR 10-2016-0061092 A (LG CHEM, LTD.) 31 May 2016 (2016-05-31)<br>See paragraphs [0030]-[0045] and claim 1. | 1-20 |
| A | JP 2012-050213 A (HITACHI LTD.) 08 March 2012 (2012-03-08)<br>See paragraphs [0046]-[0048] and claims 1-4. | 1-20 |
| A | KR 10-2016-0047157 A (LG CHEM, LTD.) 02 May 2016 (2016-05-02)<br>See paragraph [0057] and claim 1. | 1-20 |
| A | KR 10-2017-0142451 A (LG CHEM, LTD.) 28 December 2017 (2017-12-28)<br>See paragraphs [0017]-[0025] and claim 1. | 1-20 |

☐ Further documents are listed in the continuation of Box C.　　☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **14 October 2024** | **14 October 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/009663**

| Patent document cited in search report | | | Publication date (day/month/year) | Patent family member(s) | | | Publication date (day/month/year) |
|---|---|---|---|---|---|---|---|
| KR | 10-2019-0023295 | A | 08 March 2019 | CN | 110015163 | A | 16 July 2019 |
| | | | | CN | 110015163 | B | 25 April 2023 |
| | | | | EP | 3451436 | A1 | 06 March 2019 |
| | | | | JP | 2019-041566 | A | 14 March 2019 |
| | | | | JP | 7130437 | B2 | 05 September 2022 |
| | | | | KR | 10-2399604 | B1 | 18 May 2022 |
| | | | | US | 11133536 | B2 | 28 September 2021 |
| | | | | US | 2019-0067755 | A1 | 28 February 2019 |
| KR | 10-2016-0061092 | A | 31 May 2016 | KR | 10-1726927 | B1 | 13 April 2017 |
| JP | 2012-050213 | A | 08 March 2012 | CN | 102386457 | A | 21 March 2012 |
| | | | | CN | 102386457 | B | 20 January 2016 |
| | | | | EP | 2424070 | A2 | 29 February 2012 |
| | | | | EP | 2424070 | A3 | 01 July 2015 |
| | | | | EP | 2424070 | B1 | 26 October 2016 |
| | | | | JP | 5679738 | B2 | 04 March 2015 |
| KR | 10-2016-0047157 | A | 02 May 2016 | KR | 10-1709553 | B1 | 23 February 2017 |
| KR | 10-2017-0142451 | A | 28 December 2017 | KR | 10-2592332 | B1 | 19 October 2023 |

Form PCT/ISA/210 (patent family annex) (July 2022)

**REFERENCES CITED IN THE DESCRIPTION**

**Patent documents cited in the description**

- KR 1020230099066